# EUROPEAN PATENT APPLICATION

(11) **EP 4 628 942 A1**
(43) Date of publication of application: **08.10.2025**
(21) Application number: 23897649.2
(22) Date of filing: 22.11.2023
(51) Int. Cl.: G01T 1/20

(54) **RADIATION DETECTION PANEL AND RADIATION DETECTION PANEL MANUFACTURING METHOD**

(30) Priority: 02.12.2022 JP 2022193435
(71) Applicant: Canon Electron Tubes & Devices Co., Ltd., Otawara-shi, Tochigi 324-0036 (JP)
(72) Inventor: IZUMI, Takashi, Otawara-shi, Tochigi 324-0036 (JP); AIDA, Hiroshi, Otawara-shi, Tochigi 324-0036 (JP); SHIMBA, Yuichi, Otawara-shi, Tochigi 324-0036 (JP)
(74) Representative: Henkel & Partner mbB
(86) International application number: PCT/JP2023/042006
(87) International publication number: WO 2024/117001

(57) **Abstract**

This radiation detection panel comprises: a photoelectric conversion substrate (2) having a plurality of photoelectric conversion units (2b); a scintillator layer (5) provided on the photoelectric conversion substrate (2) and having one surface (5a) facing the photoelectric conversion substrate (2) and another surface (5b) positioned on the side opposite of the one surface (5a); and a reflective layer (6) that is provided to the other surface (5b) and is formed by an adhesive (61) and light scattering particles (62), wherein the reflective layer (6) has a facing surface (63) facing the other surface (5b), and a recess-and-protrusion surface (64) positioned on the side opposite of the facing surface (63), the recess-and-protrusion surface (64) has surfaces of a plurality of protrusions (64a) and surfaces of recesses (64b), the plurality of protrusions (64a) have protrusions (64a) adjacent to the respective protrusions (64a), and the spacing from the respective protrusions (64a) to the adjacent protrusions (64a) is random.

## Description

### Technical Field

Embodiments described herein relate generally to a radiation detection panel and a method of manufacturing the radiation detection panel.

### Background Art

An example of a radiation detector is an X-ray detector. An X-ray detector includes a photoelectric conversion substrate on which a plurality of photoelectric conversion elements are provided in a grating pattern, a scintillator layer provided on the photoelectric conversion substrate, and a light reflective layer formed on the scintillator layer. It is known that the light reflective layer is formed by applying a mixture material of a resin-based adhesive, light scattering particles, and a solvent to the scintillator layer with a dispenser, and then drying the applied mixture material.

### Citation List

### Patent Literature

Patent Literature 1: JP 2010-145351 A

### Summary of Invention

### Technical Problem

Embodiments described herein aim to provide a radiation detection panel and a method of manufacturing the radiation detection panel capable of improving quality of detected images.

### Solution to Problem

According to one embodiment, a radiation detection panel comprises: a photoelectric conversion substrate including a plurality of photoelectric conversion units converting fluorescence into electric signals; a scintillator layer provided on the photoelectric conversion substrate, having one surface facing the photoelectric conversion substrate and another surface located on a side opposite to the one surface, and converting radiation into fluorescence; and a light reflective layer provided on the other surface, formed of an adhesive and light scattering particles, and reflecting fluorescence generated in the scintillator layer toward the plurality of photoelectric conversion units, wherein the light reflective layer has a facing surface facing the other surface and an uneven surface located on a side opposite to the facing surface, the uneven surface includes surfaces of a plurality of protruding protrusions that protrude away from the scintillator layer, and a surface of a recess portion that is recessed further than the plurality of protruding portions, each of the plurality of protruding portions includes a protruding portion adjacent to each of the plurality of protruding portions, and an interval from each of the plurality of protruding portions to the adjacent protruding portion is random.

According to another embodiment, a method of manufacturing a radiation detection panel comprises: preparing a photoelectric conversion substrate including a plurality of photoelectric conversion units converting incident fluorescence into electric signals; forming on the photoelectric conversion substrate a scintillator layer which has one surface facing the photoelectric conversion substrate and another surface located on a side opposite to the one surface, and which converts radiation into fluorescence; preparing a first mixed material formed of an adhesive, light scattering particles, and a solvent that dissolves the adhesive; processing the first mixed material into a plurality of particles to form a plurality of second mixed materials each of which is a particle formed of the adhesive, the light scattering particles, and the solvent; spraying the plurality of second mixed materials onto the other surface; and forming a light reflective layer reflecting fluorescence generated in the scintillator layer toward the plurality of photoelectric conversion units, by drying the plurality of second mixture materials sprayed onto the other surface.

### Brief Description of Drawings

FIG. 1 is a cross-sectional view showing an X-ray detector according to an embodiment.
FIG. 2 is a perspective view showing a support substrate, an X-ray detection panel, a circuit board, and a plurality of FPC of the X-ray detector according to the embodiment, also showing an image transmission unit.
FIG. 3 is an enlarged cross-sectional view showing a part of the X-ray detection module of the X-ray detector according to the embodiment.
FIG. 4 is an enlarged cross-sectional view showing one of a plurality of mixtures shown in FIG. 3.
FIG. 5 is a plan view showing a part of a light reflective layer of the X-ray detector according to the embodiment, as viewed from a moisture-proof cover side.
FIG. 6 is a cross-sectional view along line A-A in FIG. 5.
FIG. 7 is a cross-sectional view along line B-B in FIG. 5.
FIG. 8 is a plan view taken along arrow C in FIG. 6, showing a part of a facing surface of the light reflective layer.
FIG. 9 is a plan view showing the X-ray detection module of the X-ray detector according to the embodiment.
FIG. 10 is a cross-sectional view showing the X-ray detection module taken along line D-D in FIG. 9.
FIG. 11 is a cross-sectional view showing an example of forming the light reflective layer in the X-ray detection panel according to the embodiment.

### Mode for Carrying Out the Invention

Embodiments of the present invention will be described hereinafter with reference to the accompanying drawings. The disclosure is merely an example, and proper changes within the spirit of the invention, which are easily conceivable by a person of ordinary skill in the art, are included in the scope of the invention as a matter of course. In addition, in some cases, in order to make the description clearer, the widths, thicknesses, shapes and the like, of the respective parts are schematically illustrated in the drawings, compared to the actual modes. However, the schematic illustration is merely an example, and adds no restriction to the interpretation of the invention. Besides, in the specification and drawings, the same elements as those described in connection with preceding drawings are denoted by like reference numbers, and a detailed description thereof is omitted unless necessary.

First, a basic concept of the embodiments of the present invention will be described.

An example of the radiation detector is an X-ray detector. An X-ray flat panel detector using an active matrix system has been developed as an X-ray detector. The X-ray detector comprises an X-ray detection panel as a radiation detection panel. The X-ray detection panel comprises a scintillator layer, a photoelectric conversion substrate, and the like. The photoelectric conversion substrate includes a substrate formed of glass, and a circuit layer which includes a photoelectric conversion unit, lines formed on the substrate and the like. The photoelectric conversion unit includes a photoelectric conversion element such as an amorphous silicon (a-Si) photodiode or a charge coupled device (CCD).

A scintillator layer is formed above the photoelectric conversion unit.

The material of the scintillator layer is, for example, thallium-activated cesium iodide. The resolution characteristics of the scintillator layer can be improved by forming grooves by dicing, depositing the scintillator layer by a vacuum evaporation method, or the like.

The X-ray detector outputs a digital signal of an X-ray image or a real-time X-ray image by detecting the emitted X-rays. More specifically, the X-ray detector converts the incident X-rays into fluorescence that is visible light, using the scintillator layer that is a fluorescent converter, and converts the fluorescence into an electrical signal using a photoelectric conversion element, thereby acquiring the X-ray image as a digital signal.

A sealant is provided around the scintillator layer. The sealant is formed of thermoplastic resin that contains polypropylene as a main component. Furthermore, the scintillator layer is covered with a moisture-proof cover. The moisture-proof cover is provided for the purpose of preventing the scintillator layer from being deteriorated due to moisture in the atmosphere. The moisture-proof cover has, for example, a laminated structure of a metal layer formed of aluminum or the like and a resin layer formed of PET or the like. In addition, the moisture-proof cover is joined to the sealant. The scintillator layer is located in a space sealed by the photoelectric conversion substrate, the sealant, and the moisture-proof cover.

The X-ray detection panel further comprises a light reflective layer. The light reflective layer is located between the scintillator layer and the moisture-proof cover. The light reflective layer is provided to improve the efficiency of use of the fluorescence from the scintillator layer and to improve the sensitivity characteristics of the X-ray detector. The light reflective layer reflects the fluorescence traveling toward the side opposite to the photoelectric conversion unit, thereby increasing the fluorescence that reaches the photoelectric conversion unit.

It is known that the light reflective layer is formed by a method of forming a film of a metal with high fluorescent reflectance, such as a silver (Ag) alloy or aluminum, on the scintillator layer, or a method of applying a mixed material (paste material) formed of an adhesive, light scattering particles, or the like, with a dispenser. The viscosity of the above-mentioned mixed material is, for example, 2,000 mPa·s. When the light reflective layer is formed by applying the mixed material, the light reflective layer is formed by drying the applied mixed material. At this time, the mixed material may be compressed and the scintillator layer may be peeled off due to a tensile stress caused by this compression. In addition, the X-ray detection panel may be deformed.

Furthermore, the light reflective layer formed by applying the mixed material as described above has a periodic uneven surface on the side opposite to the photoelectric conversion substrate. In this case, since the X-ray detector detects irregularity corresponding to the unevenness as an image, image quality may be degraded.

Therefore, the embodiments of the present invention are intended to solve such problems, and provide a radiation detection panel and a method for manufacturing a radiation detection panel capable of improving the quality of images detected. Means and methods for solving the above problems will be described below.

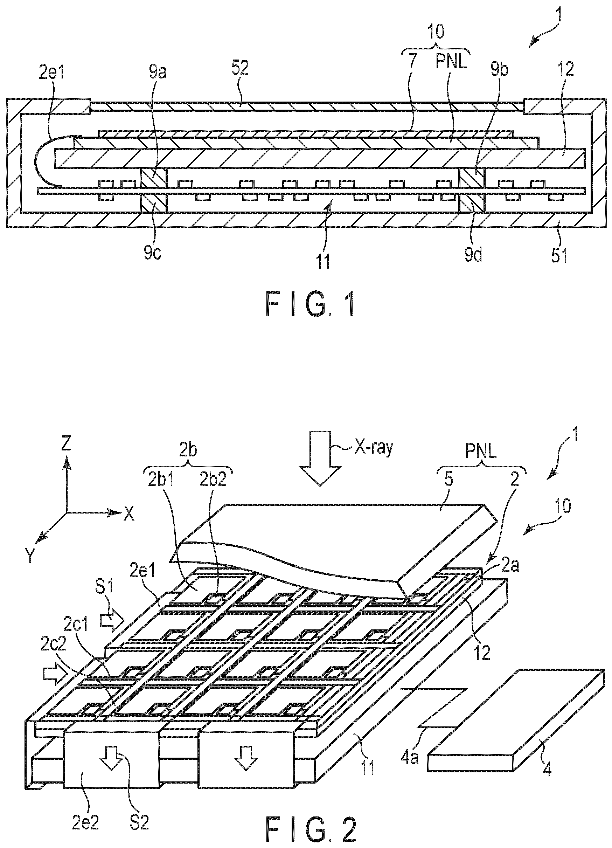

FIG. 1 is a cross-sectional view showing an X-ray detector 1 according to an embodiment. The X-ray detector 1 is an X-ray image detector, and is an X-ray flat panel detector using an X-ray detection panel as a radiation detection panel.

As shown in FIG. 1, the X-ray detector 1 comprises an X-ray detection module 10, a support substrate 12, a circuit board 11, spacers 9a, 9b, 9c, and 9d, a housing 51, a flexible printed circuit (FPC) 2e1, an incident window 52, and the like. The X-ray detection module 10 comprises an X-ray detection panel PNL. The X-ray detection panel PNL is located between the support substrate 12 and the incident window 52. The X-ray detection panel PNL includes a moisture-proof cover 7 facing the incident window 52.

The incident window 52 is attached to an opening of the housing 51. The incident window 52 transmits X-rays. For this reason, the X-rays are transmitted through the incident window 52 and made incident on the X-ray detection module 10. The incident window 52 is formed in a plate shape and comprises a function of protecting the inside of the housing 51. The incident window 52 is desirably formed of a material with a low X-ray absorption rate and formed to be thin. The scattering of the X-rays and the attenuation of the X-ray dose, which occur at the incident window 52, can be thereby reduced. Then, a thin and lightweight X-ray detector 1 can be realized. In the present embodiment, the incident window 52 is formed of carbon-fiber-reinforced plastic (CFRP).

The X-ray detection module 10, the support substrate 12, the circuit board 11, the FPC 2e1, and the like are housed inside a space surrounded by the housing 51 and the incident window 52.

Since the X-ray detection module 10 is constructed by stacking thin members, the module is lightweight and has a low mechanical strength. For this reason, the X-ray detection panel PNL (X-ray detection module 10) is fixed to one flat surface of the support substrate 12 via an adhesive sheet. The support substrate 12 is formed of, for example, an aluminum alloy, in a plate shape, and has a strength necessary to stably hold the X-ray detection panel PNL. It is thereby possible to suppress damage to the X-ray detection panel PNL when vibration or shock is applied to the X-ray detector 1 from the outside.

The circuit board 11 is fixed to the other surface of the support substrate 12 via the spacers 9a and 9b. The circuit board 11 is located at an interval from the X-ray detection panel PNL (i.e., a photoelectric conversion substrate 2 to be described later). A distance of electric insulation from the support substrate 12, which is mainly formed of metal, to the circuit board 11, can be maintained by using the spacers 9a and 9b.

The circuit board 11 is fixed to the inner surface of the housing 51 via the spacers 9c and 9d. A distance of electric insulation from the housing 51, which is mainly formed of metal, to the circuit board 11, can be maintained by using the spacers 9c and 9d. The housing 51 supports the support substrate 12 and the like via the circuit board 11 and the spacers 9a, 9b, 9c, and 9d.

A connector corresponding to the FPC 2e1 is mounted on the circuit board 11, and the FPC 2e1 is electrically connected to the circuit board 11 via the connector. A thermocompression bonding method using an anisotropic conductive film (ACF) is used to connect the FPC 2e1 with the X-ray detection panel PNL. This method ensures electrical connection between a plurality of fine pads of the X-ray detection panel PNL and a plurality of fine pads of the FPC 2e1. Incidentally, the pads of the X-ray detection panel PNL will be described later.

As described above, the circuit board 11 is electrically connected to the X-ray detection panel PNL (photoelectric conversion substrate 2) via the connector, the FPC 2e1, and the like. The circuit board 11 electrically drives the X-ray detection panel PNL (photoelectric conversion substrate 2) and electrically processes output signals from the X-ray detection panel PNL (photoelectric conversion substrate 2).

FIG. 2 is a perspective view showing the support substrate 12, the X-ray detection panel PNL, the circuit board 11, and a plurality of FPCs 2e1 and 2e2 of the X-ray detector 1 according to the embodiment, also showing an image transmission unit 4. Incidentally, FIG. 2 does not show all the members of the X-ray detector 1. Illustration of several members of the X-ray detector 1, such as a light reflective layer to be described later, is omitted in FIG. 2.

As shown in FIG. 2, the X-ray detection panel PNL comprises a photoelectric conversion substrate 2, a scintillator layer 5, and the like. The photoelectric conversion substrate 2 includes a substrate 2a, a photoelectric conversion unit 2b, a plurality of control lines (or gate lines) 2c1, a plurality of data lines (or signal lines) 2c2, and the like. Incidentally, the number, arrangement, and the like of the photoelectric conversion unit 2b, the control lines 2c1, and the data lines 2c2 are not limited to the example in FIG. 2.

The plurality of control lines 2c1 extend in the row direction X and are arranged and spaced apart at predetermined intervals in the column direction Y. The plurality of data lines 2c2 extend in the column direction Y, intersect the plurality of control lines 2c1, and are arranged and spaced part at predetermined intervals in the row direction X. A direction orthogonal to the row direction X and the column direction Y is referred to as an orthogonal direction Z.

The plurality of photoelectric conversion units 2b are provided on the scintillator layer 5 side of the substrate 2a. The photoelectric conversion units 2b are provided in quadrangular areas partitioned by the control lines 2c1 and the data lines 2c2. One photoelectric conversion unit 2b corresponds to one pixel of an X-ray image. The plurality of photoelectric conversion units 2b are arrayed in a matrix. Based on the above, the photoelectric conversion substrate 2 is an array substrate.

Each of the photoelectric conversion units 2b includes a photoelectric conversion element 2b1 and a thin film transistor (TFT) 2b2 serving as a switching element. The TFT 2b2 is connected to one corresponding control line 2c1 and one corresponding data line 2c2. The photoelectric conversion element 2b1 is electrically connected to the TFT 2b2.

The control line 2c1 is electrically connected to the circuit board 11 via the FPC 2e1. The circuit board 11 supplies a control signal S1 to the plurality of control lines 2c1 via the FPC 2e1. The data line 2c2 is electrically connected to the circuit board 11 via the FPC 2e2. An image data signal S2 converted by the photoelectric conversion element 2b1 (i.e., an electric charge accumulated in the photoelectric conversion unit 2b) is transmitted to the circuit board 11 via the TFT 2b2, the data line 2c2, and the FPC 2e2.

The X-ray detector 1 further comprises an image transmission unit 4. The image transmission unit 4 is connected to circuit board 11 via a line 4a. Incidentally, the image transmission unit 4 may be incorporated into the circuit board 11. The image transmission unit 4 generates an X-ray image, based on image data signals converted into digital signals by a plurality of analog-to-digital converters (not shown). The generated X-ray image data is output from the image transmission unit 4 to an external device.

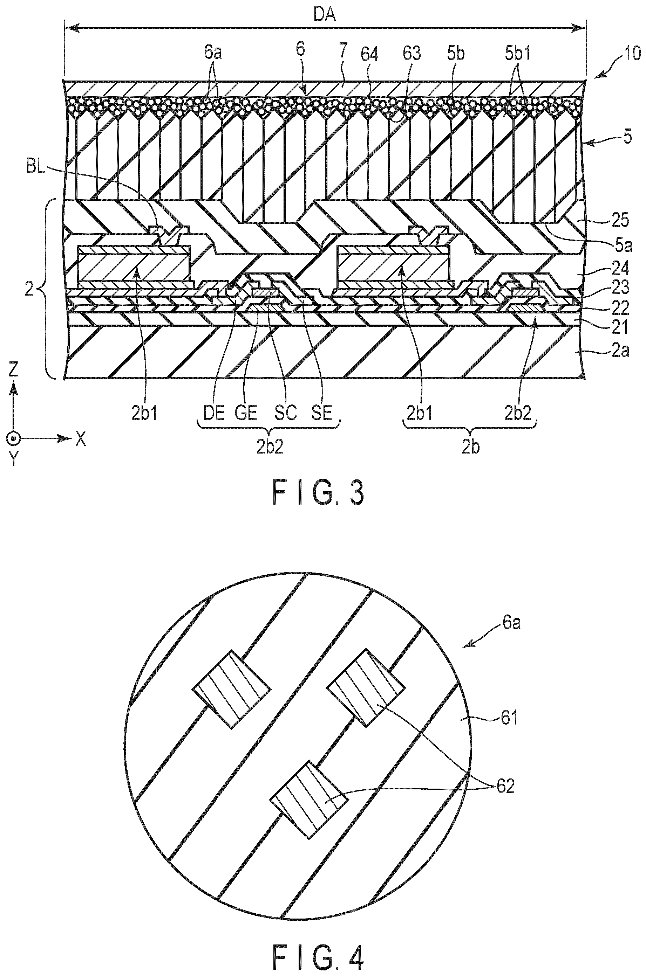

FIG. 3 is an enlarged cross-sectional view showing a part of the X-ray detection module 10 of the X-ray detector 1 according to the embodiment.

As shown in FIG. 3, the photoelectric conversion substrate 2 includes the substrate 2a, the plurality of photoelectric conversion units 2b, and insulating layers 21, 22, 23, 24, and 25. The plurality of photoelectric conversion units 2b are located in the detection area DA. Each of the photoelectric conversion units 2b comprises the photoelectric conversion element 2b1 and the TFT 2b2, and converts incident fluorescence into an electrical signal (in one example, an image data signal). The detection area DA is an area where fluorescence can reach the photoelectric conversion unit 2b when X-rays are made incident on the scintillator layer 5 and fluorescence is emitted.

The TFT 2b2 includes a gate electrode GE, a semiconductor layer SC, a source electrode SE, and a drain electrode DE. The photoelectric conversion element 2b1 is composed of a photodiode. Incidentally, the photoelectric conversion element 2b1 may be composed of CCD or the like, and may be configured to convert light into electric charge.

The substrate 2a has a plate-like shape and is formed of an insulating material. Examples of the insulating material include glass such as alkali-free glass. The planar shape of the substrate 2a is, for example, a quadrangle. The thickness of the substrate 2a is, for example, 0.7 mm. The insulating layer 21 is provided on the substrate 2a.

The gate electrode GE is formed on the insulating layer 21. The gate electrode GE is electrically connected to the control line 2c1. The insulating layer 22 is provided on the insulating layer 21 and the gate electrode GE. The semiconductor layer SC is provided on the insulating layer 22 and faces the gate electrode GE. The semiconductor layer SC is formed of a semiconductor material such as amorphous silicon used as an amorphous semiconductor, polycrystalline silicon used as a polycrystalline semiconductor, indium gallium zinc oxide (IGZO) used as an oxide semiconductor, or the like.

The source electrode SE and the drain electrode DE are provided on the insulating layer 22 and the semiconductor layer SC. The gate electrode GE, the source electrode SE, the drain electrode DE, the control line 2c1, and the data line 2c2 are formed of a low-resistance metal such as aluminum or chromium.

The source electrode SE is electrically connected to a source area of the semiconductor layer SC. In addition, the source electrode SE is electrically connected to the data line 2c2. The drain electrode DE is electrically connected to a drain area of the semiconductor layer SC.

The insulating layer 23 is provided on the insulating layer 22, the semiconductor layer SC, the source electrode SE, and the drain electrode DE. The photoelectric conversion element 2b1 is electrically connected to the drain electrode DE. The insulating layer 24 is provided on the insulating layer 23 and the photoelectric conversion element 2b1. A bias line BL is provided on the insulating layer 24, and is connected to the photoelectric conversion element 2b1 through a contact hole formed in the insulating layer 24. The insulating layer 25 is provided on the insulating layer 24 and the bias line BL.

The insulating layers 21, 22, 23, 24, and 25 are formed of an insulating material such as an inorganic insulating material or an organic insulating material. Examples of the inorganic insulating material include oxide insulating materials, nitride insulating materials, and oxynitride insulating materials. Examples of the organic insulating material include resins.

The scintillator layer 5 is provided on the plurality of photoelectric conversion units 2b. The scintillator layer 5 is located at least in the detection area DA and covers upper parts of the plurality of photoelectric conversion units 2b. The scintillator layer 5 converts incident radiation (in one example, X-rays) into fluorescence.

Incidentally, the photoelectric conversion element 2b1 converts the fluorescence made incident from the scintillator layer 5 into electric charge. The converted electric charge is stored in the photoelectric conversion element 2b1. The TFT 2b2 can switch between charging the photoelectric conversion element 2b1 and discharging from the photoelectric conversion element 2b1. Incidentally, when the self-capacitance of the photoelectric conversion element 2b1 is insufficient, the photoelectric conversion substrate 2 may further include capacitors (storage capacitors) and store the electric charge converted by the photoelectric conversion element 2b1 in the capacitor.

The scintillator layer 5 is provided on the photoelectric conversion substrate 2, and has one surface 5a facing the photoelectric conversion substrate, and another surface 5b located on the side opposite to the one surface.

The scintillator layer 5 is formed of thallium-activated cesium iodide (CsI : Tl). If the scintillator layer 5 is formed using a vacuum evaporation method, the scintillator layer 5 formed of an aggregate of a plurality of columnar crystals can be obtained. Each of the plurality of columnar crystals has a tapered upper end portion 5b1 whose diameter gradually narrows. The other surface 5b is composed of the surfaces of the plurality of upper end portions 5b1.

The thickness of the scintillator layer 5 is, for example, 600 µm. On the outermost surface of the scintillator layer 5, the columnar crystals of the scintillator layer 5 have a thickness of 3 to 10 µm.

The material for forming the scintillator layer 5 is not limited to thallium-activated cesium iodide. The scintillator layer 5 may be formed of thallium-activated sodium iodide (NaI : Tl), sodium-activated cesium iodide (CsI : Na), europium-activated cesium bromide (CsBr : Eu), sodium iodide (NaI), gadolinium oxysulfide (Gd₂O₂S) or the like.

The moisture-proof cover 7 is provided above the scintillator layer 5 to cover the scintillator layer 5. Incidentally, the scintillator layer 5 has moisture absorption properties. The moisture-proof cover 7 is provided to suppress the deterioration of the characteristics of the scintillator layer 5, which is caused by the moisture contained in the atmosphere. The moisture-proof cover 7 completely covers an exposed portion of the scintillator layer 5.

The moisture-proof cover 7 is formed of a sheet containing metal. Examples of the metal include metals containing aluminum, metals containing copper, metals containing magnesium, metals containing tungsten, stainless steel, Kovar, and the like. When the moisture-proof cover 7 contains metal, the moisture-proof cover 7 can prevent or significantly suppress the permeation of moisture.

The X-ray detection panel PNL further comprises the light reflective layer 6. The light reflective layer 6 is provided on the other surface 5b of the scintillator layer. In other words, the light reflective layer 6 is provided on the X-ray incident side of the scintillator layer 5. The light reflective layer 6 is located between the scintillator layer 5 and the moisture-proof cover 7. The light reflective layer 6 is located in at least the detection area DA and covers the upper surface of the scintillator layer 5. The light reflective layer 6 is provided to increase the efficiency of use of fluorescence and improve the sensitivity characteristics. In other words, the light reflective layer 6 reflects the fluorescence that travels towards a side opposite to the side where the plurality of photoelectric conversion units 2b are provided, of the fluorescence generated in the scintillator layer 5, toward the plurality of photoelectric conversion units 2b. The light reflective layer 6 is composed of a plurality of mixtures 6a. The light reflective layer 6 has a facing surface 63 facing the other surface 5b of the scintillator layer 5 and an uneven surface 64 located on the side opposite to the facing surface 63.

FIG. 4 is an enlarged cross-sectional view showing one of the plurality of mixtures 6a shown in FIG. 3. As shown in FIG. 4, each of the plurality of mixtures 6a is a particle formed of an adhesive (binder material) 61 and light scattering particles 62. In other words, the light reflective layer 6 is formed of the adhesive 61 and the light scattering particles 62. The adhesive 61 is, for example, a resin. The adhesive 61 bonds the light scattering particles 62 to each other and bonds the light scattering particles to the scintillator layer 5. The light scattering particles 62 are, for example, titanium oxide (TiO₂). In one example, the mixture 6a includes three light scattering particles 62. Incidentally, the number of the light scattering particles 62 is not limited to three, but may be more than three or less than three. For example, the number of the light scattering particles 62 may be two or four. In one example, the light scattering particles 62 are formed in a quadrangular shape, but the shape is not limited to a quadrangular shape.

The mixture 6a shown in FIG. 4 has a spherical shape. Incidentally, the shape of the mixture 6a is not limited to a sphere. For example, each mixture 6a may be recessed at a location where the mixture is in contact with the other surface 5b of the scintillator layer 5 or the other mixture 6a. The size of the mixture 6a is approximately 0.1 to 1 µm.

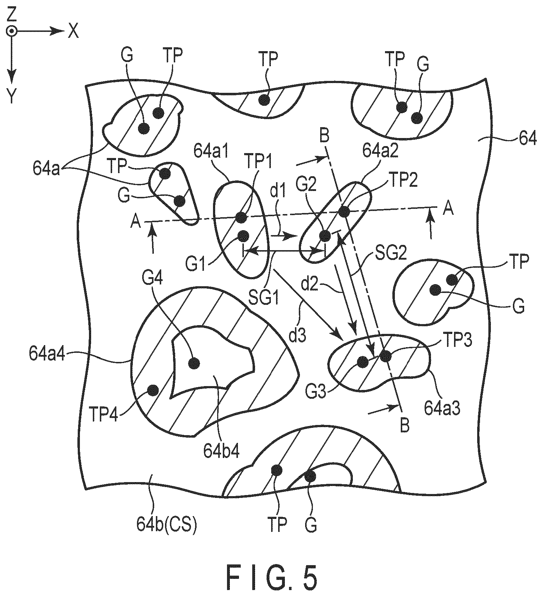

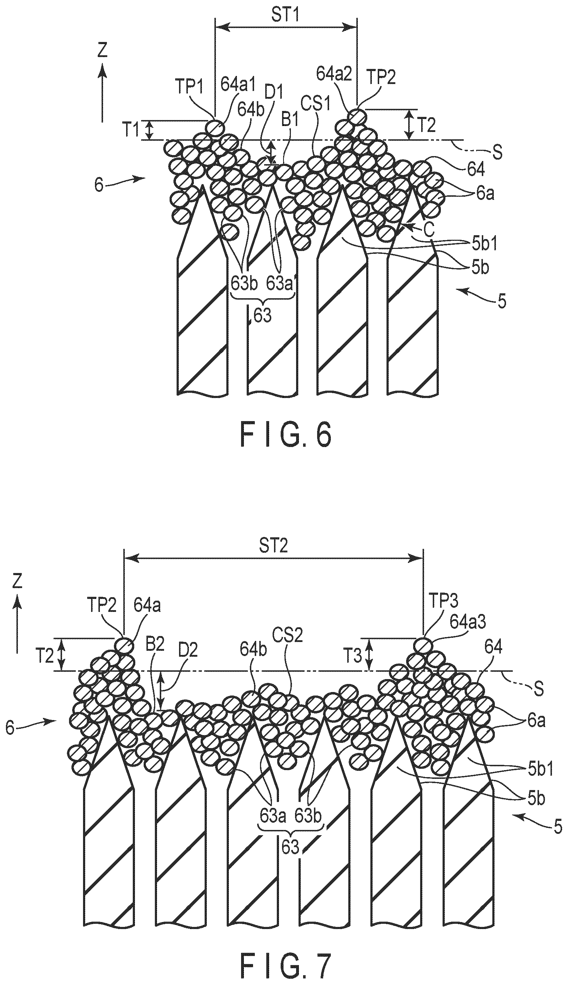

Details of the light reflective layer 6 will be described with reference to FIG. 5 to FIG. 7. FIG. 5 is a plan view showing a part of the light reflective layer 6 of the X-ray detector 1 according to the embodiment, as viewed from the moisture-proof cover 7 side. In FIG. 5, protruding portions 64a of the light reflective layer 6, which will be described later, are marked with diagonal lines slanting upward to the right. In addition, the center of gravity G and a top portion TP of each protruding portion are also shown. FIG. 6 is a cross-sectional view along line A-A in FIG. 5. FIG. 7 is a cross-sectional view along line B-B in FIG. 5. FIG. 6 and FIG. 7 are enlarged views showing the light reflective layer 6 and the scintillator layer 5, including the top portion TP of each protruding portion 64a. In addition, a position of an imaginary plane S shown in FIG. 6 is the same as a position of an imaginary plane S shown in FIG. 7, in the orthogonal direction Z.

As shown in FIG. 5, the uneven surface 64 includes surfaces of a plurality of protruding portions 64a and a surface of a recess portion 64b. The plurality of protruding portions 64a have adjacent protruding portions 64a. For example, the first protruding portions 64a are adjacent to a second protruding portion 64a2, a third protruding portion 64a3, a fourth protruding portion 64a4, and the like. As described above, each of the plurality of protruding portions 64a is adjacent to three or more protruding portions 64a. Incidentally, each of the plurality of protruding portions 64a may be adjacent to two or less protruding portions. The plurality of protruding portions 64a may be located in a straight line.

The direction from each of the plurality of protruding portions 64a to the adjacent protruding portion 64a is random. More specifically, the direction from the center of gravity G of each of the plurality of protruding portions 64a to the center of gravity G of the adjacent protruding portion 64a is random. For example, a direction d1 from a center of gravity G1 of the first protruding portion 64a1 to a center of gravity G2 of the second protruding portion 64a2 is different from a direction d2 from the center of gravity G2 of the second protruding portion 64a2 to a center of gravity G3 of the third protruding portion 64a3. In addition, when each of the plurality of protruding portions 64a is adjacent to the plurality of protruding portions 64a, the directions from each of the plurality of protruding portions 64a to its adjacent protruding portions 64a are random. For example, the direction d1 from the center of gravity G1 of the first protruding portion 64a1 to the center of gravity G2 of the second protruding portion 64a2 is different from the direction d2 from the center of gravity G1 of the first protruding portion 64a1 to the center of gravity G3 of the third protruding portion 64a3.

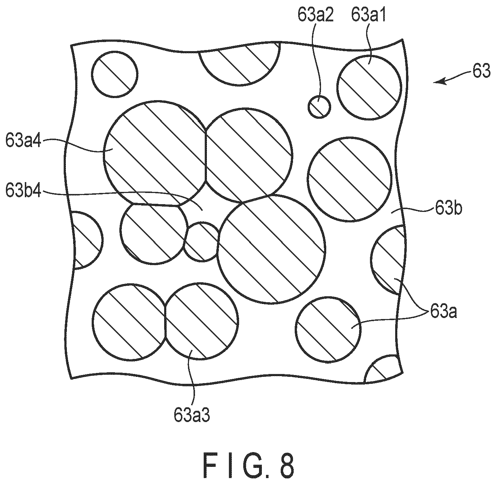

As shown in FIG. 6 and FIG. 7, the facing surface 63 includes a plurality of contact surfaces 63a that are in contact with and fixed to the other surface 5b, and a non-contact surface 63b that faces the other surface 5b to be spaced apart by a gap. In other words, the light reflective layer 6 has the contact surfaces 63a that are in contact with and fixed to the other surface 5b, and the non-contact surface 63b that are positioned to be separated from the other surface 5b, on the facing surfaces 63 that face the other surfaces 5b of the scintillator layer 5. Details of the facing surface 63 will be described later in descriptions of FIG. 8.

The uneven surface 64 includes surfaces of a plurality of protruding portions 64a that protrude away from the scintillator layer 5, and surface of recess portion 64b that is recessed further than the plurality of protruding portions 64a. In one example, the direction in which the protruding portions 64a protrude coincides with the orthogonal direction Z. Each of the plurality of protruding portions 64a is formed of a plurality of mixtures 6a. The protruding portion 64a is located on the upper side (i.e., the side opposite to the scintillator layer 5) of a reference imaginary plane S in the orthogonal direction Z. The recess portion 64b is located on the lower side (the scintillator layer 5 side) of the imaginary plane S in the orthogonal direction Z.

Incidentally, the imaginary plane S is a plane orthogonal to the direction in which the plurality of protruding portions 64a protrude (in one example, the orthogonal direction Z). The imaginary plane S can be set at any position in the orthogonal direction Z between a maximum position where the height of the uneven surface 64 is maximum and a minimum position where the height of the uneven surface 64 is minimum. The imaginary plane S can be set at, for example, an intermediate position between the maximum position and the minimum position.

An interval from each of the plurality of protruding portions 64a to the adjacent protruding portion 64a is random. In other words, the interval from each of the plurality of protruding portions 64a to the adjacent protruding portion 64a is not uniform.

More specifically, the interval from the center of gravity G of each of the plurality of protruding portions 64a to the center of gravity G of the adjacent protruding portion 64a is random. For example, an interval SG1 from the center of gravity G1 of the first protruding portion 64a1 to the center of gravity G2 of the second protruding portion 64a2 is different from an interval SG2 from the center of gravity G2 of the second protruding portion 64a2 to the center of gravity G3 of the third protruding portion 64a3 (see FIG. 5). Incidentally, in the present embodiment, the interval from the top portion TP of each of the plurality of protruding portions 64a to the top portion TP of the adjacent protruding portion 64a is also random. For example, an interval ST1 from a top portion TP1 of the first protruding portion 64a1 to a top portion TP2 of the second protruding portion 64a2 is different from an interval ST2 from the top portion TP2 of the second protruding portion 64a2 to the third protruding portion 64a3 (see FIG. 6 and FIG. 7).

The heights of the plurality of protruding portions 64a are random. More specifically, for the plurality of protruding portions 64a, the heights from the imaginary planes S (hereinafter simply referred to as the "same imaginary planes S") that are at the same position in the orthogonal direction Z to the respective top portions TP are random. In other words, for the plurality of protruding portions 64a, the heights from the same imaginary plane S to the respective top portions are not uniform. For example, the height T1 from the imaginary plane S to the top portion TP1 is different from the height T2 from the imaginary plane S to the top portion TP2 and the height T3 from the imaginary plane S to the top portion TP3.

The plurality of protruding portions 64a have a random shape in a first cross section parallel to the direction in which the plurality of protruding portions 64a protrude. In other words, the shapes of the plurality of protruding portions 64a are not uniform, in the first cross section. For example, in FIG. 6, the shape of the first protruding portion 64a1 is different from the shape of the second protruding portion 64a2. In addition, in FIG. 7, the shape of the second protruding portion 64a2 is different from the shape of the third protruding portion 64a3. Incidentally, the cross sections shown in FIG. 6 and FIG. 7 are cross sections that include the top portion TP. However, the first cross section is not limited to the cross section including the top portion TP. In other words, the plurality of protruding portions 64a have a random shape, even in a cross section which is parallel to the direction of protrusion of the plurality of protruding portions 64a protrude and which does not include the top portion TP.

The concave surface CS, which is the surface of the recess portion 64b, has a first concave surface CS1 located between the first protruding portion 64a1 and the second protruding portion 64a2, and a second concave surface CS2 located between the second protruding portion 64a2 and the third protruding portion 64a3. The depth of the concave surface CS is random. More specifically, the depth from the same imaginary plane S to the concave surface CS is random, in the first cross section. In other words, the depth from the same imaginary plane S to the concave surface CS is not uniform, in the first cross section. For example, in the first cross section, a depth D1 from the same imaginary plane S to a bottom B1 of the first concave surface CS1 is different from a depth D2 from the same imaginary plane S to a bottom B2 of the second concave surface CS2.

As shown in FIG. 5, the plurality of protruding portions 64a are formed in a random shape in plan view seen from the moisture-proof cover 7 side. In other words, when a cross section orthogonal to the direction in which the plurality of protruding portions 64a protrude is referred to as a second cross section, the shapes of the plurality of protruding portions 64a are random in second cross sections that are at the same position in the orthogonal direction Z (hereinafter simply referred to as "the same second cross section"). Incidentally, the second cross section is a cross section between the position where the height of the uneven surface 64 is maximum and the position where the height of the uneven surface 64 is minimum, in the orthogonal direction Z.

In other words, the shapes of the plurality of protruding portions 64a are not uniform in the same second cross section. For example, in the same second cross section, the shape of the first protruding portion 64a1 is different from the shape of the second protruding portion 64a2 and the shape of the third protruding portion 64a3. In summary, the shapes of the plurality of protruding portions 64a are random in the first cross section (see FIG. 6 and FIG. 7) and the second cross section.

The plurality of protruding portions 64a include a frame-shaped fourth protruding portion 64a4. A recess portion 64b4 is located inside the fourth protruding portion 64a. The recess portion 64b4 is independent of the other recess portions 64b. As described above, the uneven surface 64 may include the surfaces of the plurality of recess portions 64b.

The plurality of protruding portions 64a have random areas in plan view seen from the moisture-proof cover 7 side. In other words, the areas of the plurality of protruding portions 64a are random in the same second cross section. In other words, the areas of the plurality of protruding portions 64a are not uniform in the same second cross section. For example, in the same second cross section, the area of the first protruding portion 64a1 is different from the area of the second protruding portion 64a2, the area of the third protruding portion 64a3, and the area of the fourth protruding portion 64a4. Since the heights to the top portions of the plurality of protruding portions 64a are random (see FIG. 6 and FIG. 7) and since the areas of the plurality of protruding portions 64a in the second cross section are random, the sizes of the plurality of protruding portions 64a are random.

FIG. 8 is a plan view taken along arrow C in FIG. 6, showing a part of the facing surface 63 of the light reflective layer 6. In FIG. 8, the contact surface 63a is marked with diagonal lines slanting downward to the right.

As shown in FIG. 8, the sizes of the plurality of contact surfaces 63a are random. In other words, the sizes of the plurality of contact surfaces 63a are not uniform. For example, the size of the first contact surface 63a1 is different from the size of the second contact surface 63a2. When the mixture 6a has a spherical shape without a depression and is in point contact with the other surface 5b, the facing surface 63 includes a point where the mixture 6a is in contact with the other surface 5b.

The plurality of contact surfaces 63a include contact surfaces 63a formed of the surface of one mixture 6a, such as the first contact surface 63a1 and the second contact surface 63a2, and contact surfaces 63a formed of the surfaces of the plurality of mixtures 6a, such as the third contact surface 63a3 and the fourth contact surface 63a4. The shapes of the contact surfaces 63a composed of the surfaces of the plurality of mixtures 6a are random. For example, the shape of the third contact surface 63a3 is different from the shape of the fourth contact surface 63a4.

The fourth contact surface 63a4 is formed in a frame shape, and a non-contact surface 63b4 is located inside the fourth contact surface 63a4. The non-contact surface 63b4 is independent of the other non-contact surfaces 63b. As described above, the facing surface 63 may include a plurality of non-contact surfaces 63b.

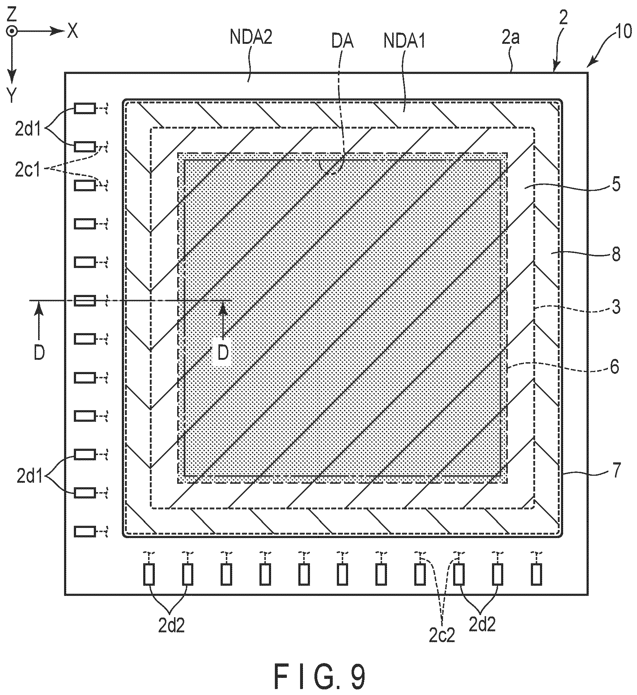

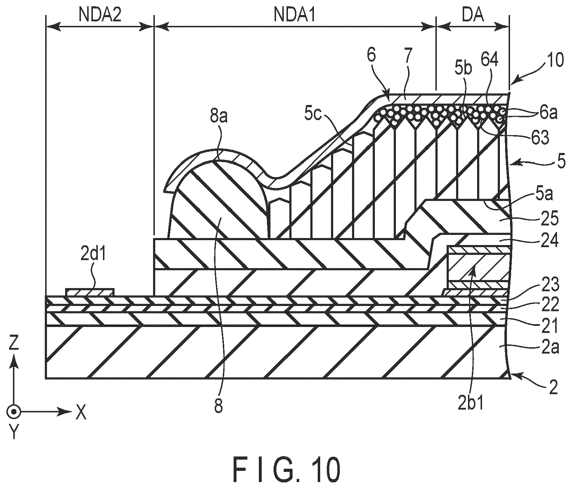

FIG. 9 is a plan view showing the X-ray detection module 10 of the X-ray detector 1 according to the embodiment. In FIG. 9, the scintillator layer 5 is marked with diagonal lines rising upward to the right, and the sealant 8 is marked with diagonal lines falling downward to the right. FIG. 10 is a cross-sectional view showing the X-ray detection module 10 taken along line D-D in FIG. 9.

As shown in FIG. 9 and FIG. 10, the photoelectric conversion substrate 2 has a detection area DA and a non-detection area outside the detection area DA. The detection area DA is a quadrangular area. The non-detection area of the photoelectric conversion substrate 2 includes a frame-shaped first non-detection area NDA1 located around the detection area DA, and a second non-detection area NDA2 outside the first non-detection area NDA1. In the embodiment, the second non-detection area NDA2 has a frame shape.

The scintillator layer 5 is located in at least the detection area DA. The scintillator layer 5 has one surface 5a, the other surface 5b, and a side surface 5c. The side surface 5c is located in the first non-detection area NDA1. The side surface 5c is a forward tapered surface.

The photoelectric conversion substrate 2 further includes a plurality of pads 2d1 and a plurality of pads 2d2. The pads 2d1 and the pads 2d2 are located in the second non-detection area NDA2. In the present embodiment, the plurality of pads 2d1 are arranged along the left side of the substrate 2a, and the plurality of pads 2d2 are arranged along the lower side of the substrate 2a. For example, the pads 2d1 and 2d2 are provided on the insulating layer 23 and are not covered with the insulating layer 24 and the insulating layer 25.

The X-ray detection module 10 further comprises a sealant 8. The sealant 8 is located in the first non-detection area NDA1 and surrounds the scintillator layer 5. The sealant 8 has a frame-like shape and extends continuously around the scintillator layer 5. The sealant 8 is adhered to the photoelectric conversion substrate 2 (for example, the insulating layer 25).

If a shape of an outer surface 8a of the sealant 8 is a curved surface protruding to the outward, the vicinity of the periphery of the moisture-proof cover 7 can easily be made to conform to the outer surface 8a of the sealant 8.

The light reflective layer 6 and the moisture-proof cover 7 is located in the detection area DA and the first non-detection area NDA1. The moisture-proof cover 7 completely covers the scintillator layer 5 in the plan view shown in FIG. 9. The moisture-proof cover 7 covers at least a part of the sealant 8.

The scintillator layer 5 includes voids of approximately 10 to 40% of its volume. For this reason, if gas is contained in the voids, the gas may expand and damage the moisture-proof cover 7 if the X-ray detector 1 is transported by aircraft or if the X-ray detector 1 is used at high altitudes. If the moisture-proof cover 7 and the sealant 8 are joined in an environment in which a pressure is lower than atmospheric pressure, damage to the moisture-proof cover 7 can be suppressed even if the X-ray detector 1 is transported by aircraft or the like. Based on the above, the pressure in the space surrounded by the photoelectric conversion substrate 2, the sealant 8, and the moisture-proof cover 7 is desirably lower than atmospheric pressure.

The X-ray detector 1 of the present embodiment is configured as described above.

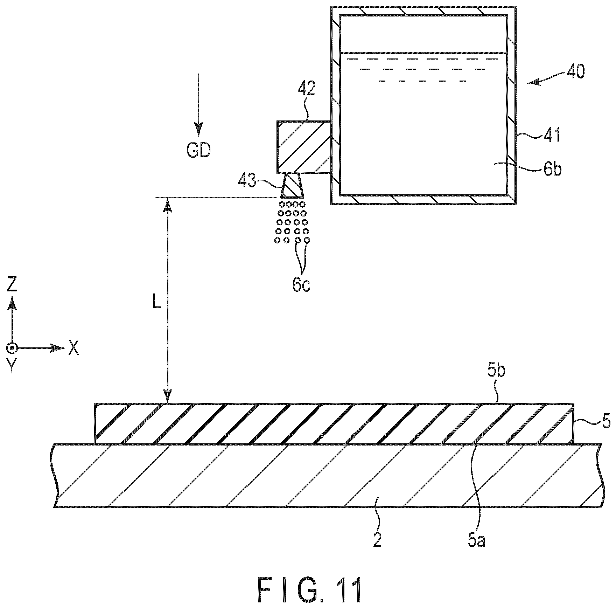

Next, a method for manufacturing the X-ray detection panel PNL according to the above embodiment will be described. FIG. 11 is a cross-sectional view showing an example of forming the light reflective layer 6 in the X-ray detection panel PNL according to the above-described embodiment.

As shown in FIG. 11, when manufacturing the X-ray detection panel PNL is started, first, the photoelectric conversion substrate 2 is prepared and the scintillator layer 5 is formed on the photoelectric conversion substrate 2. Next, a first mixed material 6b formed of an adhesive 61, light scattering particles 62, and a solvent dissolving the adhesive 61 is prepared. In one example, the first mixed material 6b is formed by mixing the adhesive 61, the light scattering particles 62, and the solvent.

The solvent is, for example, an organic solvent such as cyclohexanone, and dissolves the adhesive 61. The solvent imparts fluidity to the first mixed material 6b, improving its applicability (spreadability). For example, if the first mixed material 6b is formed only of the adhesive 61 and the light scattering particles 62, the viscosity is too high and the applicability (spreadability) is not good. The viscosity of the first mixed material 6b is, for example, approximately 2,000 mPa·s. In addition, the first mixed material 6b is stored in a container 41 of a sprayer 40.

After that, by processing the first mixed material 6b into a plurality of particles, a plurality of second mixed materials 6c each of which is a particle formed of the adhesive 61, the light scattering particles 62, and the solvent, are formed, and the plurality of second mixed materials 6c are sprayed onto the other surface 5b of the scintillator layer 5. More specifically, the first mixed material 6b is converted into granular (mist) second mixed materials 6c by a spray nozzle 42 of the sprayer 40, and the plurality of second mixed materials 6c are sprayed from a spray port 43 of the sprayer 40 toward the scintillator layer 5. In one example, the direction in which the plurality of second mixed materials 6c are sprayed coincides with a direction of gravity GD. Incidentally, the direction in which the plurality of second mixed materials 6c are sprayed is not limited to coinciding with the direction of gravity GD, but may be, for example, a direction orthogonal to the direction of gravity GD.

At this time, the mixed materials are desirably sprayed in a state in which a distance L from the scintillator layer 5 to the spray port 43 is long. For example, by setting the distance L to approximately 50 cm, the plurality of protruding portions 64a provided at random intervals on the light reflective layer 6 can easily be formed.

Incidentally, the method of forming the plurality of second mixed materials 6c from the first mixed material 6b and spraying the plurality of second mixed materials 6c is not limited to the method using the sprayer 40.

Subsequently, the plurality of second mixed materials 6c sprayed on the other surface are dried to form the light reflective layer 6. More specifically, when the solvent in the plurality of second mixed materials 6c evaporates, the plurality of second mixed materials 6c become a plurality of mixtures 6a, thereby forming the light reflective layer 6. Accordingly, manufacturing the X-ray detection panel PNL is ended.

The drying can be performed in, for example, a desiccator in which dry air is flowed. The drying temperature can be set to, for example, room temperature. The drying time can be appropriately changed depending on the ratio of the solvent, the thickness of the layer of the plurality of sprayed second mixed materials 6c, the drying conditions, and the like.

When the plurality of second mixed materials 6c are sprayed as described above, the solvent also evaporates between the spray port 43 and the other surface 5b of the scintillator layer 5. Therefore, the tensile stress that the scintillator layer receives when the second mixed materials 6c are dried can be suppressed as compared to the case when the first mixed material 6b is applied to the scintillator layer 5 with a dispenser. In addition, the drying time can be reduced to 1/10 or less as compared to when the first mixed material 6b is applied to the scintillator layer 5 with a dispenser. The drying time in the present embodiment is, for example, approximately 30 minutes.

The advantages of the present embodiment will be described.

According to the radiation detection panel and the method of manufacturing the radiation detection panel according to the present embodiments configured as described above, the radiation detection panel comprises the reflective layer 64 having the uneven surface 64 including the surfaces of the plurality of protruding portions 64a. An interval from each of the plurality of protruding portions 64a to the adjacent protruding portion 64a is random.

In the radiation detector comprising the light reflective layer 6 having the uneven surface including the surfaces of plurality of protruding portions located at periodic intervals, irregularity corresponding to the unevenness of the light reflective layer 6 is detected when an X-ray image is acquired.

In contrast, in the radiation detector comprising the light reflective layer having the uneven surface including the surfaces of the plurality of protruding portions where the intervals from each protruding portion to the adjacent protruding portion are random, irregularity corresponding to the unevenness is not detected when an X-ray image is acquired. In other words, a radiation detection panel capable of improving the quality of detected images can be obtained.

The direction from each of the plurality of protruding portions 64a to the adjacent protruding portion 64a is random.

The sizes of the plurality of protruding portions 64a are random.

In the first cross section and the second cross section, the shapes of the plurality of protruding portions 64a are random.

In the first cross section, the depth of the recess portions to the surface varies randomly.

Each of the plurality of protruding portions 64a is formed of a plurality of mixtures 6a.

Accordingly, the reflection of the shape produced by the scintillator layer 5 can be made more complex than that in a radiation detector having a light reflective layer with a periodic uneven surface, and the amount of fluorescence transmitted through the light reflective layer can be reduced. In other words, a radiation detection panel with high sensitivity can be obtained.

Incidentally, the periodic uneven surface refers to, for example, an uneven surface including surfaces of a plurality of protruding portions located at periodic intervals, an uneven surface including surfaces of a plurality of protruding portions located in a constant direction, an uneven surface including surfaces of a plurality of protruding portions formed in a constant size, an uneven surface including surfaces of a plurality of protruding portions formed in a constant shape, or an uneven surface including a surface of a recess portion with a constant depth.

The light reflective layer 6 has the facing surface 63 facing the other surface 5b of the scintillator layer 5. The facing surface 63 includes a plurality of contact surfaces 63a that are in contact with and fixed to the other surface 5b, and non-contact surface 63b that faces the other surface to be spaced apart by a gap.

The light reflective layer 6 is composed of a plurality of mixtures 6a each of which is a particle formed of an adhesive and light scattering particles.

The tensile stress that the scintillator layer 5 receives as a result of the compression (drying) of the mixed materials (in one example, the plurality of second mixed materials 6c) of the light reflective layer 6 attached to the other surface 5b is increased as the area of contact between the mixed material and the scintillator layer 5 increases. Since the tensile stress that the scintillator layer 5 receives can be reduced by reducing the above area, peeling of the scintillator layer 5 and deformation of the X-ray detection panel PNL, which are caused by compression of the mixed materials, can be suppressed.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the invention. The accompanying claims and their equivalents are intended to cover such forms or modifications as would fall within the scope and spirit of the inventions.

## Claims

1. A radiation detection panel comprising:
a photoelectric conversion substrate including a plurality of photoelectric conversion units converting fluorescence into electric signals;
a scintillator layer provided on the photoelectric conversion substrate, having one surface facing the photoelectric conversion substrate and another surface located on a side opposite to the one surface, and converting radiation into fluorescence; and
a light reflective layer provided on the other surface, formed of an adhesive and light scattering particles, and reflecting fluorescence generated in the scintillator layer toward the plurality of photoelectric conversion units,
wherein
the light reflective layer has a facing surface facing the other surface and an uneven surface located on a side opposite to the facing surface,
the uneven surface includes surfaces of a plurality of protruding protrusions that protrude away from the scintillator layer, and a surface of a recess portion that is recessed further than the plurality of protruding portions,
each of the plurality of protruding portions includes a protruding portion adjacent to each of the plurality of protruding portions, and
an interval from each of the plurality of protruding portions to the adjacent protruding portion is random.

2. The radiation detection panel of claim 1, wherein
a direction from a center of gravity at each of the plurality of protruding portions to a center of gravity at the adjacent protruding portion is random.

3. The radiation detection panel of claim 1, wherein
the light reflective layer is composed of a plurality of mixtures, and
each of the plurality of mixtures is a particle formed of an adhesive and light scattering particles.

4. The radiation detection panel of claim 3, wherein
each of the plurality of protruding portions is formed of the plurality of mixtures.

5. The radiation detection panel of claim 1, wherein
the facing surface includes a plurality of contact surfaces that are in contact with and fixed to the other surface, and a non-contact surface that faces the other surface to be spaced apart by a gap.

6. A method of manufacturing a radiation detection panel comprising:
preparing a photoelectric conversion substrate including a plurality of photoelectric conversion units converting incident fluorescence into electric signals;
forming on the photoelectric conversion substrate a scintillator layer which has one surface facing the photoelectric conversion substrate and another surface located on a side opposite to the one surface, and which converts radiation into fluorescence;
preparing a first mixed material formed of an adhesive, light scattering particles, and a solvent that dissolves the adhesive;
processing the first mixed material into a plurality of particles to form a plurality of second mixed materials each of which is a particle formed of the adhesive, the light scattering particles, and the solvent;
spraying the plurality of second mixed materials onto the other surface; and
forming a light reflective layer reflecting fluorescence generated in the scintillator layer toward the plurality of photoelectric conversion units, by drying the plurality of second mixture materials sprayed onto the other surface.
